# EUROPEAN PATENT APPLICATION

(11) **EP 2 264 228 A1**
(43) Date of publication of application: **22.12.2010**
(21) Application number: 09725314.0
(22) Date of filing: 26.03.2009
(51) Int. Cl.: C30B 29/38, C30B 23/06

(54) **ALN BULK SINGLE CRYSTAL, SEMICONDUCTOR DEVICE, AND PROCESS FOR PRODUCING ALN SINGLE CRYSTAL BULK**

(30) Priority: 28.03.2008 JP 2008088059; 16.03.2009 JP 2009063127
(71) Applicant: JFE Mineral Company, Ltd., Minato-ku Tokyo 105-0014 (JP); Friedrich-Alexander-Universität Erlangen-Nürnberg, 91054 Erlangen (DE); CrystAI-N GmbH, 91058 Erlangen (DE)
(72) Inventor: NAGATA, Shunro, Tokyo 1050014 (JP); WINNACKER, Albrecht, D91058 (DE); EPELBAUM, Boris M, D91058 (DE); BICKERMANN, Matthias, D91058 (DE); FILIP, Octavian, D91058 (DE); HEIMANN, Paul, D91058 (DE)
(74) Representative: Gassner, Wolfgang
(86) International application number: PCT/JP2009/056841
(87) International publication number: WO 2009/119896

(57) **Abstract**

An object of the present invention is to provide, even when a single crystal of a material other than AlN is used as a crystal, an AlN bulk single crystal having fewer defects and high quality, a method for producing such an AlN bulk single crystal, and a semiconductor device. A feature is to select, as a surface 1a of a hexagonal single crystal substrate serving as a seed crystal 1, a plane inclined at an angle of 10° to 80° with respect to the C-plane (Fig. 1(a)), and to grow an AlN single crystal 2 as a growth plane 2a on the surface 1a by a sublimation method (Fig. 1(b)).

## Description

### Technical Field

The present invention relates to a semiconductor device such as a light-emitting device, an electronic device, and a semiconductor sensor, and a method for producing an AlN single crystal; in particular, to a method for producing an AlN bulk single crystal having a large diameter by a sublimation method.

### Background Art

AlN crystals have been attracting attention in recent years as a substrate material for various semiconductor devices such as optical devices and electronic devices because AlN crystals have a wide energy band gap, high thermal conductivity, and high electrical resistance.

Conventional methods for producing an AlN single crystal include a sublimation method in which an AlN crystal material is charged into a crucible and sublimed AlN is grown as a single crystal as disclosed in Patent Document 1. This sublimation method is conducted as follows: a powder of a material for a single crystal is mixed with a powder of an oxide that reacts with the material by being heated to decompose the material and to vaporize AlN; the resultant mixed powder is heated in a nitrogen atmosphere or a nitrogen atmosphere containing hydrogen and carbon at a temperature lower than the sublimation temperature or the melting temperature of the material, thereby decomposing the mixed powder and vaporizing AlN and growing a crystal on a substrate with the resultant vaporized component.

However, the conventional method for producing an AlN single crystal by the sublimation method has the following problem. This method requires preparation of a seed crystal composed of an AlN single crystal and having a diameter similar to that of a single crystal to be grown. Such an AlN single crystal is expensive and it is extremely difficult at present to obtain an AlN bulk single crystal having a large diameter (diameter of 10 mm or more).

To overcome this problem, a method is used in which an AlN single crystal is grown on a single crystal composed of a material other than AlN. This method is disclosed, for example, in Non-Patent Documents 1 and 2 in which an AlN single crystal is grown on a SiC crystal serving as an alternative seed crystal by a sublimation method. With this method, an AlN single crystal can be grown without an AlN bulk single crystal serving as a seed crystal.

However, this method has the following problems. When a single crystal is grown on the SiC seed crystal, a C-plane wafer, which is the only commercially available product at present, is generally used as a seed crystal since it is a seed crystal having a large diameter. A SiC single crystal grown in the C-axis direction inevitably includes internal defects that have propagated in the C-axis direction. These defects propagate to an AlN single crystal that is grown on the SiC seed crystal. Furthermore, such heteroepitaxial growth in which AlN is grown on SiC can cause generation of new defects at the interface between the SiC and the AlN because of poor matching in the lattice constants, the coefficients of thermal expansion, and the like of the SiC crystal and the AlN crystal. Use of the resultant AlN single crystal for a device may cause degradation in device properties due to defects in the AlN single crystal.

A technique has been reported in recent years, for example, as disclosed in Non-Patent Document 3, in which a SiC single crystal is grown such that a crystal growth plane thereof is a plane (hereinafter, referred to as "r-plane") having any inclination other than 90° with respect to the C-plane of a seed crystal (SiC single crystal). With this technique, a SiC single crystal can be grown in a direction other than the C-axis and hence defects propagating along the C-axis are ejected to outside of the crystal as the crystal is grown. As a result, a SiC single crystal including fewer defects can be obtained.

However, growing an AlN single crystal on a SiC single crystal substrate having a r-plane has the following problem. Because of differences between SiC and AlN in terms of composition and physical property values such as a lattice constant, growing an AlN single crystal on a r-plane of a SiC substrate does not necessarily result in a decrease in defects.
Patent Document and Non-Patent Documents
Patent Document 1: Japanese Unexamined Patent Application Publication No. 10-53495
Non-Patent Document 1: V. Noveski, "MRS Internet J. Nitride Semicond. Res.", Vol. 9, 2, 2004
Non-Patent Document 2: S. Wang, "Mater. Res. Soc. Symp. Proc.", Vol. 892, FF30-06, 1, 2006
Non-Patent Document 3: Z.G. Herro, B.M. Epelbaum, M. Bickermann, C. Seitz, A. Magerl, A. Winnacker, "Growth of 6H-SIC crystals along the [01-15] direction" Journal of Crystal Growth 275, p496-503, 2005

An object of the present invention is to provide an AlN bulk single crystal having fewer defects and high quality and a method for producing such an AlN bulk single crystal by using an appropriate seed crystal on which an AlN single crystal is grown; and a semiconductor device.

### Disclosure of Invention

The inventors of the present invention have thoroughly studied how to apply the technique of using a r-plane as a crystal growth plane to the growth of an AlN single crystal. As a result, they have found that simply growing an AlN single crystal on a specific r-plane of a SiC single crystal serving as a seed crystal is advantageous in suppressing propagation of defects generated in the seed crystal to the AlN single crystal. However, they have found that, depending on the selection of a r-plane of the SiC single crystal, the generation of new defects at the interface between SiC and AlN because of poor matching between SiC and AlN remains problematic.

The inventors of the present invention have thoroughly studied how to overcome the above-described problems. As a result, they have found the following fact. When an AlN single crystal is grown in a direction other than a direction within the C-plane of a seed crystal, on a surface inclined at an angle of 10° to 80° with respect to the C-plane of a hexagonal single crystal, such as SiC, serving as the seed crystal, propagation of defects generated in the seed crystal into the AlN single crystal is effectively suppressed. In this case, the slight difference in lattice constant (C-axis: +1.1%, A-axis: -1.0%) between the SiC single crystal and the AlN single crystal can also be canceled out and hence generation of new defects due to poor matching at the interface between the seed crystal and the AlN single crystal can also be effectively suppressed.

To achieve the above-described object, the present invention includes the following elements or features:
(1) A method for producing an AlN bulk single crystal including the step of providing an AlN bulk single crystal by growing an AlN single crystal by a sublimation method on a surface of a hexagonal single crystal material serving as a seed crystal, the surface being a crystal plane inclined at an angle of 10° to 80° with respect to a C-plane;
(2) The method for producing an AlN bulk single crystal according to (1), wherein the hexagonal single crystal material is AlN, SiC, GaN, or ZnO;
(3) The method for producing an AlN bulk single crystal according to (2), wherein the hexagonal single crystal material is a SiC single crystal and the surface of the SiC single crystal is a (01-15) plane;
(4) The method for producing an AlN bulk single crystal according to any one of (1) to (3), wherein a growth plane of the provided AlN bulk single crystal is a (10-12) plane;
(5) The method for producing an AlN bulk single crystal according to any one of (1) to (4), further including the step of providing another AlN bulk single crystal by growing an AlN single crystal by a sublimation method on a surface of the provided AlN bulk single crystal serving as a new seed crystal;
(6) An AlN bulk single crystal produced by the method according to any one of (1) to (5) and having a diameter of 20 mm or more, a thickness of 2 mm or more, and a defect density of 1.0 × 10⁶/cm² or less; and
(7) A semiconductor device using the AlN bulk single crystal according to (6).

### Brief Description of Drawings

[Fig. 1] Fig. 1 is a flow chart showing a method for producing an AlN bulk single crystal according to the present invention.
[Fig. 2] Fig. 2 is a perspective view showing the habit plane of a hexagonal single crystal serving as a seed crystal.
[Fig. 3] Fig. 3 is a section view of a single crystal growth furnace used for producing an AlN bulk single crystal according to the present invention.

### Reference Numerals

- 1, 12: seed crystal (hexagonal single crystal material)
- 2: AlN single crystal
- 3: remained portion of AlN single crystal
- 4: cut portion of AlN single crystal
- 5: AlN bulk single crystal
- 5': second seed crystal
- 6: second AlN single crystal
- 11: single crystal growth furnace
- 13: holder
- 14: upper heating means
- 15: source material
- 16: crucible
- 17: lower heating means
- 21: habit plane of seed crystal

### Best Modes for Carrying Out the Invention

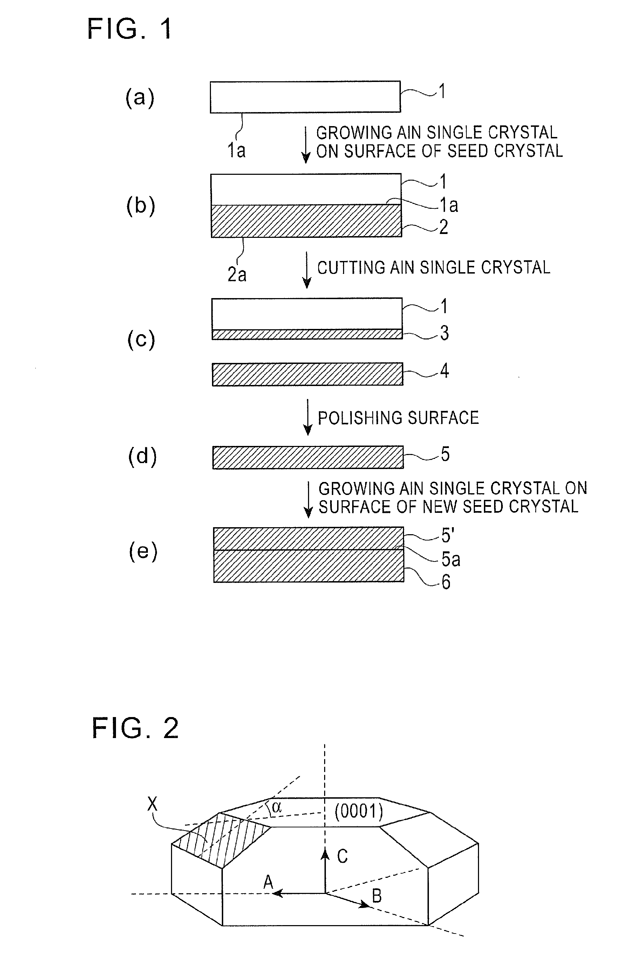

A method for producing an AlN bulk single crystal according to the present invention will be described with reference to the drawings. Fig. 1 is a flow chart schematically showing the steps of producing an AlN bulk single crystal by a production method according to the present invention.

The production method according to the present invention has a feature of using a hexagonal single crystal material as a seed crystal 1 and selecting, as a surface 1a, a crystal plane inclined at an angle of 10° to 80° with respect to the C-plane of the hexagonal single crystal material (Fig. 1(a)), and growing an AlN single crystal 2 on the surface 1a of the seed crystal 1 by a sublimation method (Fig. 1(b)). After that, the AlN single crystal 2 is cut to provide an AlN bulk single crystal 4 having fewer defects and being of high quality (Fig. 1(c)).

In the production method according to the present invention, the surface 1a is selected as a plane inclined at 10° to 80° with respect to the C-plane of the seed crystal 1 (Fig. 1(a)).

Fig. 2 shows the habit plane of the seed crystal 1. For example, consider a case where the AlN single crystal 2 is grown with a hexagonal SiC single crystal serving as the seed crystal 1. In this case, when a plane X inclined at 10° to 80° (angle α in Fig. 2) with respect to the C-plane is selected as the surface 1a, defects generated in the seed crystal 1 (SiC) disappear as the AlN single crystal is grown even though these defects have propagated to the AlN single crystal. Finally, an AlN bulk single crystal having fewer defects can be provided in which propagation of defects is suppressed. When the plane X is selected as the surface 1a, the matching of the seed crystal 1 (SiC) and the AlN single crystal at the interface 1a between the seed crystal 1 (SiC) and the AlN single crystal is good and hence generation of new defects can also be reduced. With the conventional crystal growth technique in which a (0001) plane is selected as a crystal growth plane and an AlN single crystal is grown in the C-axis direction, defects generated in the seed crystal 1 propagate in the C-axis direction. In this case, the AlN single crystal is grown and the defects propagate in the same C-axis direction. Thus, defects in the grown AlN single crystal cannot be suppressed. When an AlN single crystal is grown on a r-plane of the seed crystal 1, AlN is heteroepitaxially grown on the surface of the seed crystal 1. For this reason, the matching at the interface 1a is poor and hence new defects can be generated.

The angle α is defined in the range of 10° to 80° with respect to the C-plane by the following reason. When the inclination angle of a crystal plane serving as the surface 1a of a seed crystal with respect to the C-plane is less than 10°, there is a high probability of C-plane growth in which defects tend to propagate, being caused. When the inclination angle of a crystal plane serving as the surface 1a of a seed crystal with respect to the C-plane is more than 80°, there is a high probability of α-plane growth or m-plane growth in which growth speed is extremely low, being caused. Neither case is preferable.

The plane X inclined at 10° to 80° with respect to the C-plane of the seed crystal 1 is not particularly restricted as long as the plane X satisfies the inclination angle condition. When a SiC single crystal is used as a seed crystal, examples of the plane X include a (01-1n) plane (n is 1 to 15), a (1-10n) plane (n is 1 to 15), and a (11-2n) plane (n is 1 to 15). When the (01-1n) plane is used, the inclination with respect to the C-plane respectively changes from 80°, 70°, 62°, 54°, 48°, to 20° while n changes from 1, 2, 3, 4, 5, to 15.

The seed crystal 1 is not particularly restricted as long as the seed crystal 1 is a hexagonal single crystal. The seed crystal 1 is preferably a single crystal of AlN, SiC, GaN, or ZnO. When a single crystal other than these single crystals is used as a seed crystal, poor matching between the seed crystal and an AlN single crystal can cause generation of new defects at the interface between the seed crystal and the AlN single crystal.

When a SiC single crystal is used as the seed crystal 1, the AlN single crystal 2 is preferably grown with the (01-15) plane of the SiC single crystal serving as the surface 1a. This is because the (01-15) plane is neither parallel nor perpendicular to the C-plane, in which defects tend to propagate, and the (01-15) plane is a stable plane also appearing on a free-standing crystal of a SiC single crystal. When the AlN single crystal 2 is grown on a crystal plane other than the (01-15) plane, there is a possibility that generation of defects may not be sufficiently suppressed and new defects may be generated due to poor matching. The (01-15) plane of the SiC single crystal is inclined by about 48° with respect to the C-plane.

When the AlN single crystal 2 is grown on the (01-15) plane of the SiC single crystal serving as the seed crystal 1 (Fig. 1(b)), the growth plane of the resultant AlN bulk single crystal is a (10-12) plane, which has a small inclination of 10° or less with respect to a crystallographical C-plane of the SiC single crystal. The (10-12) plane is a naturally formed crystal growth plane in AlN single crystals. With the (10-12) plane serving as a crystal growth plane, an AlN single crystal having a growth plane that is flat and has fewer defects can be easily obtained. Thus, an AlN bulk single crystal having fewer defects and high quality can be obtained. The (01-15) plane of the SiC single crystal and the (10-12) plane of the AlN single crystal are respectively inclined by about 48° and 43° with respect to the C-plane.

In the method for producing an AlN bulk single crystal according to the present invention, the step of growing the AlN single crystal 2 (Fig. 1(b)) is conducted by a sublimation method. A growth furnace used in the sublimation method is not particularly restricted as long as the growth furnace is a commonly used single crystal growth furnace.

In the step of cutting a portion 4 constituting an AlN bulk single crystal from the AlN single crystal 2 (Fig. 1(c)), the portion 4 is preferably cut in a crystal plane parallel to a growth plane 2a of the AlN single crystal 2 in view of effectively providing an AlN bulk single crystal 5 having a large diameter. Alternatively, the portion 4 may be cut in another crystal plane. Subsequently, a surface of the cut portion 4 of the AlN single crystal is subjected to polishing or the like. As a result, the AlN bulk single crystal 5 according to the present invention is obtained.

In the method for producing an AlN bulk single crystal according to the present invention, as shown in Fig. 1(e), an AlN bulk single crystal is preferably obtained by newly using the AlN bulk single crystal 5 produced by the above-described steps (Fig. 1 (a) to (d)) as a seed crystal 5' (second seed crystal) and growing an AlN single crystal 6 (second AlN single crystal) on a surface of the seed crystal 5' by a sublimation method. Such use of the AlN bulk single crystal 5 as the new seed crystal 5' permits prevention of Si and C from entering the AlN single crystal 6. Additionally, in this case, homoepitaxial growth is conducted in which both the seed crystal 5' and the crystal 6 to be grown on the seed crystal 5' are AlN single crystals. For this reason, generation of new defects due to poor matching at an interface 5a between the seed crystal 5' and the grown crystal can be effectively suppressed.

The size of the AlN bulk single crystal 5 obtained by the production method according to the present invention can be changed in accordance with the size of the single crystal growth furnace, the application of the AlN single crystal, or the like. The AlN bulk single crystal 5 is preferably a large single crystal having a diameter of 20 mm or more and a thickness of 2 mm or more because most of the defects generated from the interface disappear and variation in crystal orientation is reduced. In this case, the AlN bulk single crystal has a low defect density of 1.0 × 10⁶/cm² or less. When the diameter is less than 20 mm, the area of the AlN bulk single crystal is not practically large. When the thickness is less than 2 mm, defects in the AlN bulk single crystal are not sufficiently suppressed. Upper limits on the diameter and the thickness are not particularly provided and the upper limits are determined by limitations of production apparatuses such as the size of a holder 13 used in crystal growth.

With an AlN bulk crystal according to the present invention, a semiconductor device with high quality can be obtained. Examples of a semiconductor device including an AlN bulk crystal according to the present invention include light-emitting devices such as light-emitting diodes and laser diodes, power transistors, and high frequency transistors.

### EXAMPLEs

### (EXAMPLE 1)

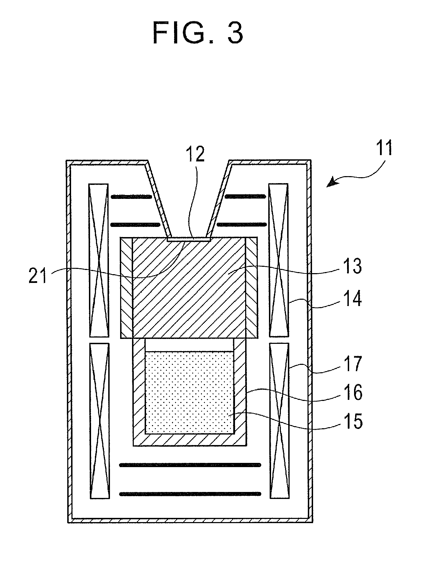

In EXAMPLE 1, a single crystal growth furnace shown in Fig. 3 was used. An AlN aggregate obtained by subjecting a commercially available AlN powder (mean particle diameter: 1.2 µm) to a heating treatment in a nitrogen atmosphere at about 1500°C to 2000°C in advance was charged as a source material 15 into the bottom of a crucible 16. A SiC single crystal having a diameter of 25 mm and a thickness of 1.0 mm serving as a seed crystal substrate 12 was placed on a holder 13 such that a surface (habit plane 21) of the seed crystal substrate 12 was a (01-15) plane. A tungsten plate (not shown) serving as a lid was put on the single crystal growth furnace. After that, the atmospheric gas was exhausted from the single crystal growth furnace 11 with an exhaust pump to reach a pressure of 1.0 × 10⁻³ Pa or less. Then, to facilitate vaporization of adsorbed oxygen from the source material 15, the crucible 16 was heated to about 400°C. Subsequently, the atmospheric gas was exhausted from the single crystal growth furnace 11 to reach a pressure of 1 × 10⁻² Pa or less. Then, a nitrogen gas was fed into the single crystal growth furnace 11. When the inner pressure of the single crystal growth furnace 11 reached a certain value (in this case, 5.0 × 10⁴ Pa), heating was conducted again until the temperature of the SiC substrate 12 reached 1800°C to 2000°C and the temperature of the material reached 2000°C to 2300°C. Then, an AlN single crystal started to grow on the habit plane 21 of the substrate 12. This crystal growth step (Fig. 1(b)) was conducted for four days until the crystal had grown to a desired thickness (10 mm in EXAMPLE 1). An AlN single crystal 2 grown on the SiC substrate 12 was cut at a position 100 µm into the AlN single crystal from the interface between the SiC substrate 12 and the AlN single crystal 2 with an inner diameter slicer. Thus, an AlN single crystal portion 4 was cut from the SiC substrate 12 (Fig. 1(c)). The cut surface of the cut AlN single crystal portion 4 was polished to provide an AlN bulk single crystal 5 serving as a sample (Fig. 1(d)).

### (EXAMPLE 2)

EXAMPLE 2 was conducted in the same manner as EXAMPLE 1 except that a step of growing an AlN single crystal 6 (Fig. 1(e)) was conducted in which the AlN bulk single crystal obtained in EXAMPLE 1 was used as a new seed crystal 5 and the new seed crystal 5 was placed on the holder 13 such that the habit plane 21 was a (01-12) plane. Thus, an AlN bulk single crystal was obtained.

### COMPARATIVE EXAMPLE

### (COMPARATIVE EXAMPLE 1)

COMPARATIVE EXAMPLE 1 was conducted in the same manner as EXAMPLE 1 except that a commercially available SiC single crystal was cut, the resultant SiC single crystal having a (0001) plane as the habit plane 21 was placed as the seed crystal substrate 12 on the holder 13, and an AlN single crystal was grown on the habit plane 21. Thus, an AlN bulk single crystal was obtained.

Hereinafter, evaluation methods used in EXAMPLEs and COMPARATIVE EXAMPLE are described.

### (Evaluation methods)

### (1) Presence or absence of impurity in AlN single crystal

The presence or absence of impurity was evaluated in accordance with the following criteria for the concentrations of Si and C contained in the AlN single crystals in EXAMPLE 1 and COMPARATIVE EXAMPLE 1 determined by GDMS (glow discharge mass spectrometry).
Good: both Si and C are 100 ppm or less
Fair: both Si and C are in the range of more than 100 ppm and 500 ppm or less; or one of Si and C is 100 ppm or less while the other is in the range of more than 100 ppm and 500 ppm or less
Poor: both Si and C are more than 500 ppm; or one of Si and C is 500 ppm or less while the other is more than 500 ppm

### (2) Defect density

The density of defects was evaluated in the following manner. A polished wafer was etched with a eutectic of potassium hydroxide and sodium hydroxide for 30 minutes. After that, the number of defects in an area of 100 µm × 100 µm was counted at five arbitrary points with an electron microscope. The average value of the resultant five counts was evaluated in accordance with the following criteria.
Good: 1.0 × 10⁶/cm² or less
Fair: more than 1.0 × 10⁶/cm² and 1.0 × 10⁷/cm² or less
Poor: more than 1.0 × 10⁷/cm²

Evaluation results of the above tests are shown in Table 1.

### Table 1

**Table 1**

| | Impurity concentration | Defect density |
|---|---|---|
| EXAMPLE 1 | Fair | Good |
| EXAMPLE 2 | Good | Good |
| COMPARATIVE EXAMPLE 1 | Fair | Poor |

As shown in EXAMPLEs 1 and 2 in Table 1, growth of an AlN single crystal on an appropriate crystal plane provides a defect density two or more orders of magnitude smaller than that of the AlN single crystal in COMPARATIVE EXAMPLE 1. As shown in EXAMPLE 2, use of a grown AlN single crystal as a new seed crystal permits growth of an AlN single crystal that is improved in impurity concentration and defect density. AlN single crystals were also produced in the same manner in which the habit planes of hexagonal single crystal materials were a (01-13) plane, a (1-105) plane, a (11-25) plane, and the like. In these cases, it has been confirmed that the produced single crystals had better defect density than that in COMPARATIVE EXAMPLE 1. It has also been confirmed that, when an AlN single crystal is grown on a crystal plane other than the above-described crystal planes, for example, a (0001) plane, the defect density of the resultant AlN single crystal was not reduced.

### Industrial Applicability

According to the present invention, even when a single crystal of a material other than AlN is used as a seed crystal, an AlN bulk single crystal having fewer defects and high quality can be provided and a method for producing such an AlN bulk single crystal and semiconductor devices can be provided.

## Claims

1. A method for producing an AlN bulk single crystal comprising the step of providing an AlN bulk single crystal by growing an AlN single crystal by a sublimation method on a surface of a hexagonal single crystal material serving as a seed crystal, the surface being a crystal plane inclined at an angle of 10° to 80° with respect to a C-plane.

2. The method for producing an AlN bulk single crystal according to Claim 1, wherein the hexagonal single crystal material is AlN, SiC, GaN, or ZnO.

3. The method for producing an AlN bulk single crystal according to Claim 2, wherein the hexagonal single crystal is a SiC substrate and the surface of the SiC substrate is a (01-15) plane.

4. The method for producing an AlN bulk single crystal according to any one of Claims 1 to 3, wherein a growth plane of the provided AlN bulk single crystal is a (10-12) plane.

5. The method for producing an AlN bulk single crystal according to any one of Claims 1 to 4, further comprising the step of providing another AlN bulk single crystal by growing an AlN single crystal by a sublimation method on a surface of the provided AlN bulk single crystal serving as a new seed

6. An AlN bulk single crystal produced by the method according to any one of Claims 1 to 5 and having a diameter of 20 mm or more, a thickness of 2 mm or more, and a defect density of 1.0 × 10⁶/cm² or less.

7. A semiconductor device using the AlN bulk single crystal according to Claim 6.
